# EUROPEAN PATENT APPLICATION

(11) **EP 2 458 637 A1**
(43) Date of publication of application: **30.05.2012**
(21) Application number: 11190052.8
(22) Date of filing: 22.11.2011
(51) Int. Cl.: H01L 27/02

(54) **Electrostatic discharge circuit**

(30) Priority: 24.11.2010 US 954221
(71) Applicant: NXP B.V., 5656 AG Eindhoven (NL)
(72) Inventor: Werber, Achim, Redhill, Surrey RH1 1DL (GB); Ritter, Hans-Martin, Redhill, Surrey RH1 1DL (GB)
(74) Representative: Hardingham, Christopher Mark

(57) **Abstract**

An integrated circuit device provides electrostatic discharge (ESD) protection. In connection with various example embodiments, an ESD circuit includes a low voltage clamp circuit configured to discharge current during an ESD event in response to a voltage level presented thereto, and is coupled across an internal node (*e.g.*, a floating circuit node or a voltage supply (VDD)) and ground, in parallel with an input node having a diode between the input node and each of the internal node and ground. The clamp circuit includes a silicon-controlled rectifier (SCR) including a thyristor having anode and cathode end regions separated by two base regions, the cathode being connected to the internal node and the anode being connected to ground. A diode string circuit is connected to one of the internal node and ground, and to one of the base regions, and a resistor is connected to the one of the internal node and ground that the diode string circuit is connected to, and to the one of the base regions that the diode string circuit is not connected to.

## Description

### Background

Modem electronic equipment, and in particular handheld equipment, is often used in harsh environments in which the equipment is subjected to potential electrostatic discharge (ESD). For instance data exchange ports such as those employed with universal serial bus (USB) or high-definition multimedia interface (HDMI) receiver/transceiver circuits are directly connected to external pins of electronic equipment. Current pulses from electrostatic discharge can have extremely fast rising slopes, such that protecting against such pulses requires rapid switching in order to shunt the current. In many instances, circuits are not robust enough to withstand the stress caused by ESD.

To address these problems, a variety of different types of ESD protection devices have been used. Such ESD protection devices generally clamp stress voltages to a level that the circuit to be protected can withstand. However, many semiconductor devices can withstand only small stress voltages as relative to small breakdown voltages of internal oxides and junctions. Accordingly, smaller clamping voltages can be desirable, while being higher than the supply voltage.

While small clamping voltages can be desirable in view of the above, small capacitance is also desirable in order to maintain high data rates, as parasitic capacitances disturb the data transmission and have to be kept small, smaller capacitances generally benefit higher data rates. However, small capacitance and small clamping voltages are conflicting targets for devices employing ESD protection, since achieving small capacitance can involve reducing the size of ESD protection devices, while smaller size leads to higher on-resistance and to higher clamping voltage. In addition, many clamping devices employ tunneling diodes that are susceptible to unacceptably high leakage currents, particularly for handheld electronics.

These and other matters have presented challenges to ESD circuit protection, and related device operation.

### Summary

Various example embodiments are directed to electrostatic discharge (ESD) protection for mixed signal devices.

In connection with an example embodiment, an electrostatic discharge (ESD) circuit includes an input node connected between an internal node (e.g., VDD or a floating circuit node) and ground, input diodes respectively connected between the input node and an internal node, and a low voltage clamp circuit. One of the input diodes has its anode connected to the input node and its cathode connected to an internal node, and another one of the input diodes has its cathode connected to the input node and its anode connected to ground. The low voltage clamp circuit is configured to discharge current during an ESD event in response to a voltage level presented thereto. This clamp circuit includes a silicon-controlled rectifier (SCR) including a thyristor having anode and cathode end regions separated by two base regions, with the cathode connected to an internal node and the anode connected to ground. A diode string circuit is connected to one of an internal node and ground, and to one of the base regions. A resistor circuit is connected to the one of an internal node and ground that the diode string circuit is connected to, and to the one of the base regions that the diode string circuit is not connected to.

Another example embodiment is directed to a discharge circuit configured to discharge electrostatic charge in a circuit including an input node respectively connected to an internal node and to ground via intervening diodes. The discharge circuit includes a thyristor having anode and cathode end regions separated by two base regions, the cathode end region being connected to the internal node and the anode end region being connected to ground. At least one diode is connected between one of the base regions of the thyristor and one of either the internal node or ground. A resistor is connected between the other one of the base regions that the at least one diode string that is not connected to and the one of either the internal node or ground that the at least one diode is connected to.

Another example embodiment is directed to an electrostatic discharge circuit for use in a circuit including an input node respectively connected to an internal node and to ground via intervening diodes. A plurality of diode-based doped regions of opposite polarity form p-n junctions therebetween, are connected between the internal node and ground, and are configured to pass current from the input node to ground in response to a voltage applied to the input node being higher than the sum of the forward voltages of one of the intervening diodes having its anode connected to the input node and the plurality of diode-based doped regions. A plurality of contiguous thyristor-based doped regions of opposite polarity are connected between the internal node and ground, the thyristor-based doped regions including two of said plurality of diode-based doped regions of opposite polarity and at least two other contiguous doped regions. A resistor is connected to one of the at least two other contiguous doped regions contacting one of the two of said plurality of diode-based doped regions. The resistor is configured, with the one of the at least two other contiguous doped regions, to flow collector current between the internal node and ground via effects of the emitter-base junctions, in response to the current passing from the input node to ground via the diode-based doped regions. The contiguous thyristor-based doped regions are further configured to, in response to the collector current through the resistor causing the voltage drop across the resistor to be higher than the forward voltage of a p-n junction of the at least two other contiguous doped regions, turn on and switch to a low resistive state to flow current between the internal node and ground.

The above discussion is not intended to describe each embodiment or every implementation of the present disclosure. The figures and following description also exemplify various embodiments.

### Brief Description of the Drawings

Various example embodiments may be more completely understood in consideration of the following detailed description in connection with the accompanying drawings, in which:
FIG. 1 shows a circuit for on-board ESD protection, according to an example embodiment of the present invention;
FIG. 2 shows another circuit for on-board ESD protection, according to an example embodiment of the present invention;
FIG. 3 shows another circuit for on-board ESD protection with two transistors, according to another example embodiment of the present invention;
FIG. 4 shows another circuit for on-board ESD protection with a dual clamp circuit, according to another example embodiment of the present invention;
FIG. 5 shows a cross section of a transistor used in an on-board ESD protection circuit, according to another example embodiment of the present invention;
FIG. 6 shows a cross section of a diode circuit used in an on-board ESD protection circuit, according to another example embodiment of the present invention;
FIG. 7 shows another cross section of a diode circuit used in an on-board ESD protection circuit, according to another example embodiment of the present invention;
FIG. 8 shows a cross section of an SCR circuit used in an on-board ESD protection circuit, according to another example embodiment of the present invention; and
FIG. 9 shows a cross section of a clamp circuit used in an on-board ESD protection circuit, according to another example embodiment of the present invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the invention including aspects defined in the claims.

The present invention is believed to be applicable to a variety of different types of processes, devices and arrangements for use with various circuits, including integrated circuits susceptible to electrostatic discharge (ESD), and related processes. While the present invention is not necessarily so limited, various aspects of the invention may be appreciated through a discussion of examples using this context.

### Detailed description

According to an example embodiment, an ESD protection circuit combines two forward fast switching/low capacitive diodes with a low voltage clamp. The voltage clamp includes a diode string triggered SCR. The forward diodes can be used to effect an overall reduction in total capacitance, via the ability to carry high current at reduced size. The SCR has deep snapback characteristics, thus reducing clamping voltage at over current stress. The diode string is configured to trigger the SCR by setting, or tuning, the breakdown voltage of the SCR. More particularly, the diode string can set the breakdown of the SCR to a voltage corresponding to a low supply voltage (e.g., as may be common in many integrated circuits, such as those used in hand-held devices). The diode string offers an additional current path parallel to the SCR that will surge stress current to ground during the first few picoseconds of the onset of the stress current, as long as the SCR has not switched to its low ohmic state. This approach may serve to maintain a low (e.g., minimum) overshoot voltage when stress event occurs (e.g., during the first picoseconds of an ESD event).

The various example embodiments described herein can be implemented in connection with a variety of different types of circuits, to protect one or several data lines. In some implementations, an ESD protection circuit as discussed herein is implemented as an external on board circuit for high data rate interfaces in handheld devices. Some applications are directed to applications with universal serial bus (USB) applications such as SuperSpeed USB applications, or high-definition multimedia interface (HDMI) receiver/transceiver circuits. In some implementations, forward diodes and the SCR are integrated in a device manufactured in a high gain bipolar process for high performance ESD structures with fast switching diodes. In addition, the number of protection channels can be extended to suit particular applications.

In various embodiments described herein, reference is made to an ESD circuit that is coupled between an internal node and ground. Many examples discuss this internal node as being connected to an internal VDD. Other examples discuss the internal node as being another type of circuit node, such as a floating node. Accordingly, while various embodiments discuss the application of an ESD circuit between ground and such an internal node, and as the figures similarly show such applications, these embodiments may be applied to connections between ground and one or more of an internal VDD, an internal floating node, and an internal node connected to an external voltage supply.

In connection with a more particular example embodiment, an ESD circuit includes a clamp circuit that discharges current during an ESD event in response to a voltage level presented thereto. The clamp circuit includes a silicon-controlled rectifier (SCR) including a thyristor having anode and cathode end regions separated by two base regions. The cathode is connected to an internal node (e.g., VDD or a floating circuit node) and the anode is connected to ground.

A diode string circuit is connected to one of the internal node and ground, and to one of the base regions. For instance, if one end of the diode string circuit is connected to the internal node, the other end of the diode string circuit is connected to a base region at the anode end of the thyristor. If one end of the diode string circuit is connected to ground, the other end of the diode string circuit is connected to a base region at the cathode end of the thyristor. With respect to either of these, a resistor circuit is connected to the one of the internal node and ground that the diode string circuit is connected to, and to the one of the base regions that the diode string circuit is not connected to.

An input node is connected between the internal node and ground, with input diodes respectively connected between the input node and the internal node and ground. One of the input diodes has its anode connected to the input node and its cathode connected to the internal node, and another one of the input diodes has its cathode connected to the input node and its anode connected to ground.

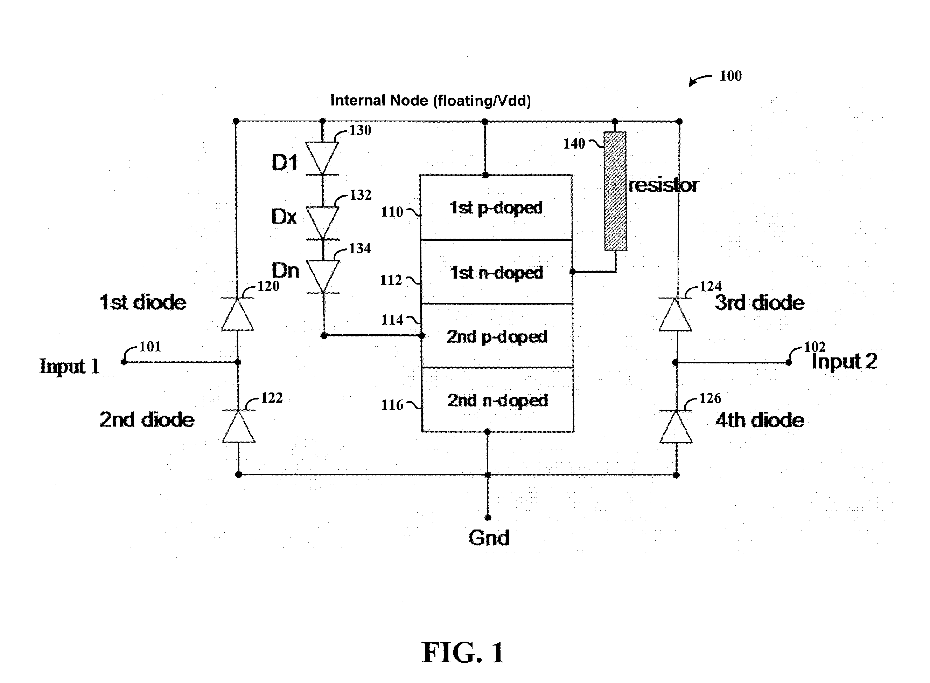

Turning now to the figures, Figure 1 shows a circuit 100 for on-board ESD protection, according to another example embodiment of the present invention. Two inputs 101 and 102 are shown (e.g., for rail-to-rail protection). Each input is connected to two diodes. A first diode 120 is connected with its anode to the first input 101, and a second diode 122 is connected with its cathode to the first input. A third diode 124 is connected with its anode to the second input 102, and a fourth diode 126 is connected with its cathode to the second input. The second and fourth diodes 122 and 126 are connected with their anodes to ground, and the first and third diodes 120 and 124 are connected with their cathodes to an internal connection. In some implementations, the internal connection to is to an internal node that is connected to an external voltage source (as an internal VDD). In other implementations, the internal connection is to another circuit nodes, such as a floating circuit node. For illustration, the following discussion refers to the internal node as VDD.

The circuit 100 also includes a silicon-controlled rectifier (SCR) having its cathode connected to VDD. The SCR includes four adjacent semiconductor regions, including a first p-doped region 110 in contact with a first n-doped region 112, a second p-doped region 114 in contact with the first n-doped region, and a second n-doped region 116 in contact with the second p-doped region. The first p-doped region 110, the first n-doped region 112 and the second p-doped region 114 form a pnp-transistor of the SCR. The second n-doped region 116, the second p-doped region 114 and the first n-doped region 112 form an npn-transistor of the SCR. The first p-doped region 110 is the cathode of the SCR and is connected to VDD, and the second n-doped region 116 is the anode of the SCR and is connected to ground.

The circuit 100 further includes a diode string including one or more diodes, represented here by reference to diodes D1 130, Dx 132 through diode Dn 134, with the diodes connected in series. The anode of the first diode 130 is connected to the internal connection to Vdd, and the cathode of the last diode Dn 134 is connected to the second p-doped region 114 of the SCR. This p-doped region 114 is the base of the npn-transistor of the SCR formed with the n-doped regions 112 and 116. The diode string including "n" diodes D1 to Dn, and the base-emitter diode of the npn-transistor (114, 116) are all connected in series.

In addition to the diode string, a resistor 140 is connected between the internal connection to VDD and the first n-doped region 112 of the SCR. Characteristics of the resistor 140 can be set to control the operation of the SCR, as discussed further below.

Current flows from the input to ground when a voltage applied to one of the inputs is higher than the sum of the forward voltages of: the diode connected to the input (120/124), the diodes D1 to Dn (130-134) of the diode string, and the base-emitter diode of the npn transistor. This current flows through the emitter-base junction of the npn transistor at 114 and 116. This base current leads to a collector current flowing from the internal node Vdd through the resistor 140 to the collector 112 of the npn transistor, through the base (114) of the npn and to the emitter (116) of the npn. If the collector (112) current is high enough so that the voltage drop across the resistor 140 is higher than the forward voltage of the diode between the first p-doped region 110 and the first n-doped region 112, then current will flow through that diode, the SCR will turn on and switch to a low resistive state.

As long as the SCR has not switched on, the characteristics seen at the inputs 101 or 102 versus ground are similar to that of a diode string of n+2 diodes (n being the number of diodes in the string shown as including diodes 130, 132 and 134). As soon as the SCR has switched to its low resistive state, the characteristics will be similar to that of a forward diode in series with a thyristor.

Using this approach, a snap-back type of characteristic (as described above) can be achieved for the circuit 100, which can be used to address ESD current. The value of the resistor 140 is set to define the current level needed for snap back. The number n of diodes D1 to Dn (130, 132, 134) is chosen to set the voltage level needed for snap back. Accordingly, the voltage visible at the inputs 101 and 102 can be set by the number of these diodes. For example, with n=3 as shown, the breakdown voltage is defined by five forward voltages (*e.g.*, 3.5 V). For general information regarding ESD devices, and for specific information regarding snapback behavior (*e.g.*, as may be achieved using one or more approaches as discussed herein), reference may be made to "A synthesis of ESD input protection scheme," by Ch. Duvvury and R. Rountree, Journal of Electrostatics, 29 (1992), pp 1-19, which is fully incorporated herein by reference.

In many implementations, the diodes connected to the inputs (120, 122, 124, 126) are low-capacitance diodes, and exhibit a relatively fast turn on time (set via the geometry of the diodes and the doped regions). The diode string (130, 132, 134) and the effective bipolar transistor therein provide an additional current path to shunt ESD events to GND The fast turn on time of the high performance bipolar transistors facilitates a relatively low, or minimum, over voltage peaks after the first few picoseconds during a positive ESD event. As the first n-doped region 112 and the 2^{nd} p-doped region 114 are shorted, the diodes in the diode string (130, 132, 134) do not have a parasitic transistor to ground connection.

For negative stress applications, the circuit 100 operates with a relatively low clamping voltage, as set via the one diode to GND as shown for shunting current *(see, e.g.,* diode 122). During positive stress, the current path includes a diode plus a clamp *(see, e.g.,* diode 120 and the clamp circuit including 110, 112, 114 and 116). The holding voltage is the sum of the SCR clamping controlled by the diode string (130, 132, 134) plus the forward voltage drop of the low capacitance diode (*e.g.*, 122).

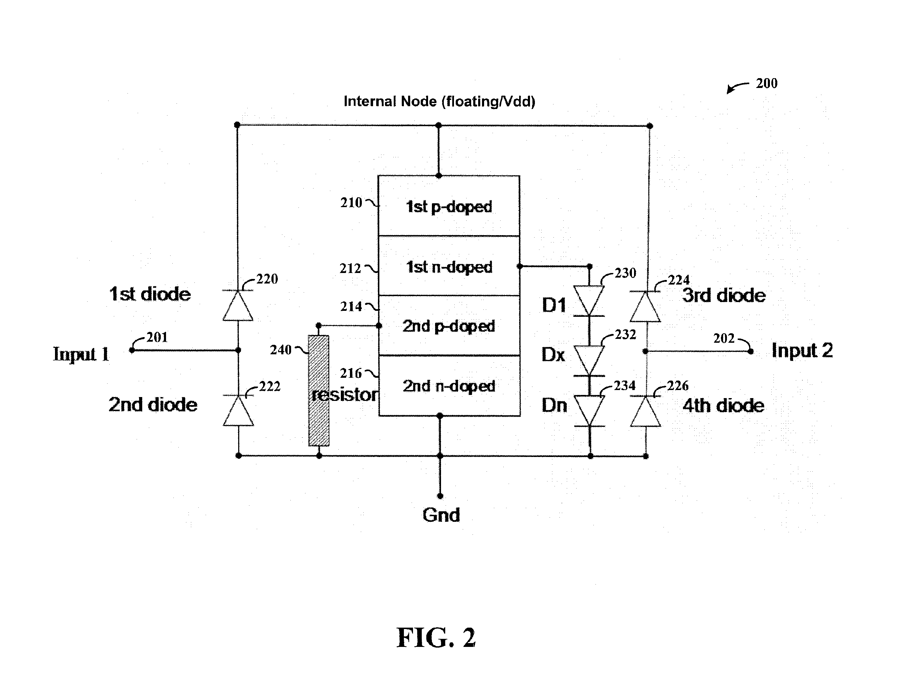

The following discussion of the figures refers to circuits that effect ESD protection in a manner similar to that shown in FIG. 1. Accordingly, various components in the figures are labeled using similar reference numbers (*e.g.*, diode 220 in FIG. 2 corresponds to diode 120 in FIG. 1). In this regard, detailed discussion of some of these aspects is omitted for brevity.

FIG. 2 shows another circuit 200 for on-board ESD protection, according to another example embodiment of the present invention. The circuit 200 is similar in function to that shown in FIG. 1, having inputs 201 and 202 respectively coupled to diodes 220, 222 and 224, 226, and a clamping device including an SCR (210, 212, 214, 216), diode string 230, 232, 234 and a resistor 240. Here, the diode string is coupled at the anode of D1 (230) to first n-doped (base) region 212, and at the cathode of Dn (234) to ground. The resistor 240 is connected between the 2^{nd} p-doped (base) region 214 and ground. Operation of the circuit 200 is similar to that as discussed above in connection with the circuit 100 in FIG. 1.

Another example embodiment is directed to an electrostatic discharge circuit for use in a circuit including an input node respectively connected to a voltage supply VDD and to ground via intervening diodes. This embodiment may, for example, be applied in connection with one or both of the circuits shown in FIG. 1 and FIG. 2 above. Accordingly, the following discussion makes reference to certain circuit components described above by way of example.

A plurality of diode-based doped regions of opposite polarity form p-n junctions therebetween, are connected between VDD and ground, and are configured to pass current from the input node to ground (*e.g.*, diodes 130, 132, 134 and p-n regions 114 and 116). The diode-based doped regions pass current in response to a voltage applied to the input node being higher than the sum of the forward voltages of one of the intervening diodes having its anode connected to the input node and the plurality of diode-based doped regions.

A plurality of contiguous thyristor-based doped regions of opposite polarity are connected between VDD and ground, the thyristor-based doped regions including two of said plurality of diode-based doped regions of opposite polarity (*e.g.*, 114, 116) and at least two other contiguous doped regions (*e.g.*, 110, 112). A resistor (*e.g.,* 140) is connected to one of the at least two other contiguous doped regions (*e.g.*, 112) contacting one of the two of said plurality of diode-based doped regions. The resistor is configured, with the one of the at least two other contiguous doped regions (*e.g.*, 112), to flow collector current between VDD and ground via effects of the emitter-base junctions (*e.g.*, 114, 116), in response to the current passing from the input node to ground via the diode-based doped regions (*e.g.*, 130, 132, 134, 114, 116). The contiguous thyristor-based doped regions are further configured to, in response to the collector current through the resistor causing the voltage drop across the resistor to be higher than the forward voltage of a p-n junction of the at least two other contiguous doped regions, turn on and switch to a low resistive state to flow current between VDD and ground (*e.g.*, via 110, 112, 114, 116).

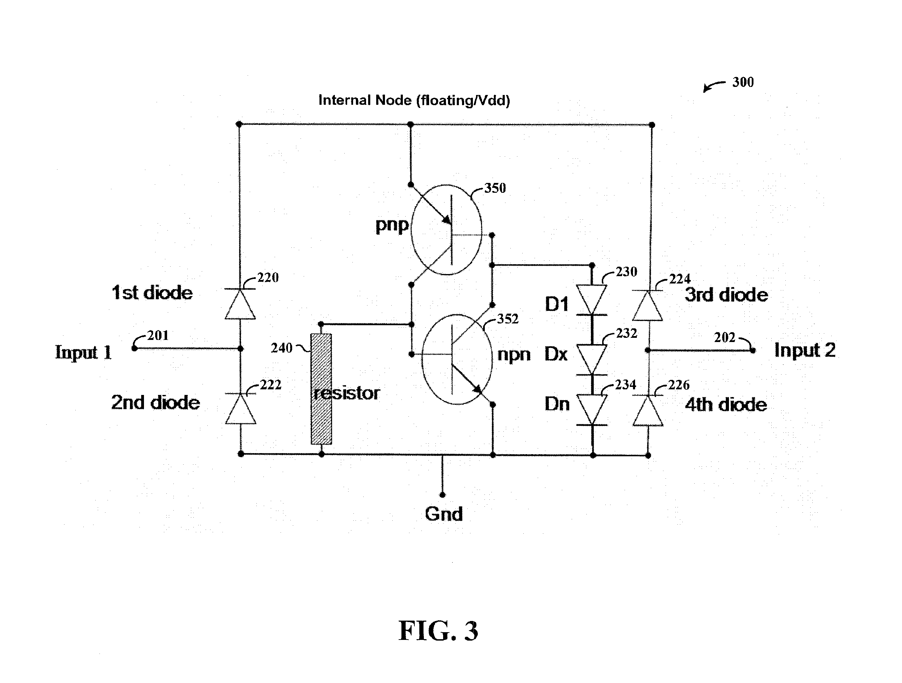

FIG. 3 shows another circuit 300 for on-board ESD protection with two transistors, according to another example embodiment of the present invention. The circuit 300 generally corresponds to the circuit 200 in FIG. 2, with identical reference numbers used for various components. Referring to the clamp portion of the circuit 300, the thyristor of FIG. 2 (110, 112, 114, and 116) is represented by separate pnp and npn transistors 350 and 352. Operation can be implemented as discussed above.

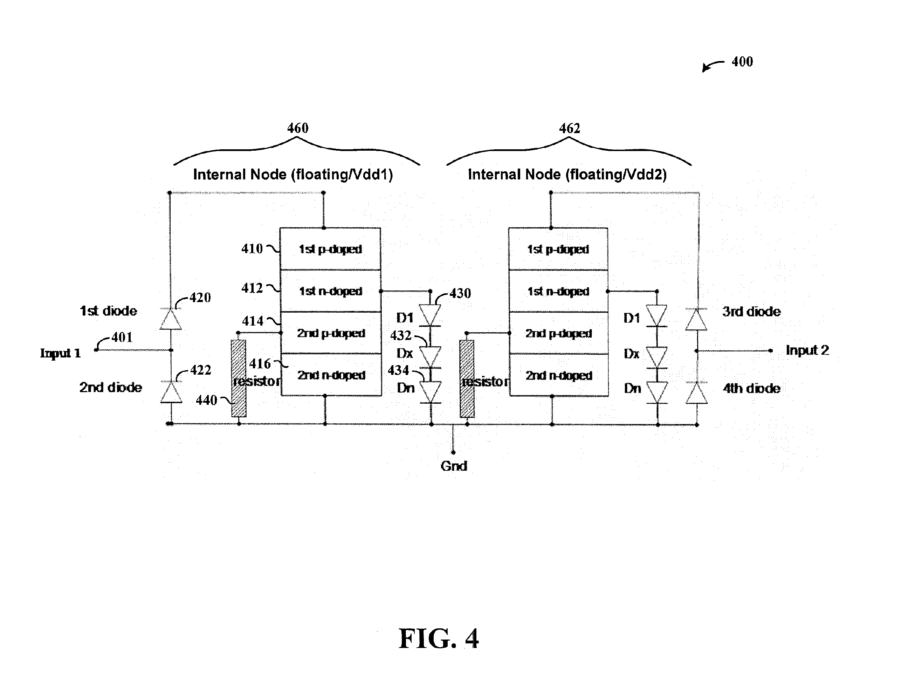

FIG. 4 shows a dual clamp circuit 400 for on-board ESD protection, according to another example embodiment of the present invention. The circuit 400 includes two clamp circuits 460 and 462, with each circuit being similar to the circuit 200 shown in FIG. 2. Each of the respective clamp circuits 460 and 462 is connected to an internal VDD, and to a common ground. By way of example, components of clamp circuit 460 are labeled with reference numbers similar to those shown in FIG. 2 (e.g., diode 420 corresponds to diode 220), with description omitted for brevity. In accordance with this example, and as consistent with other embodiments discussed herein, the number of inputs is not limited to two, and two or more clamp circuits may be used.

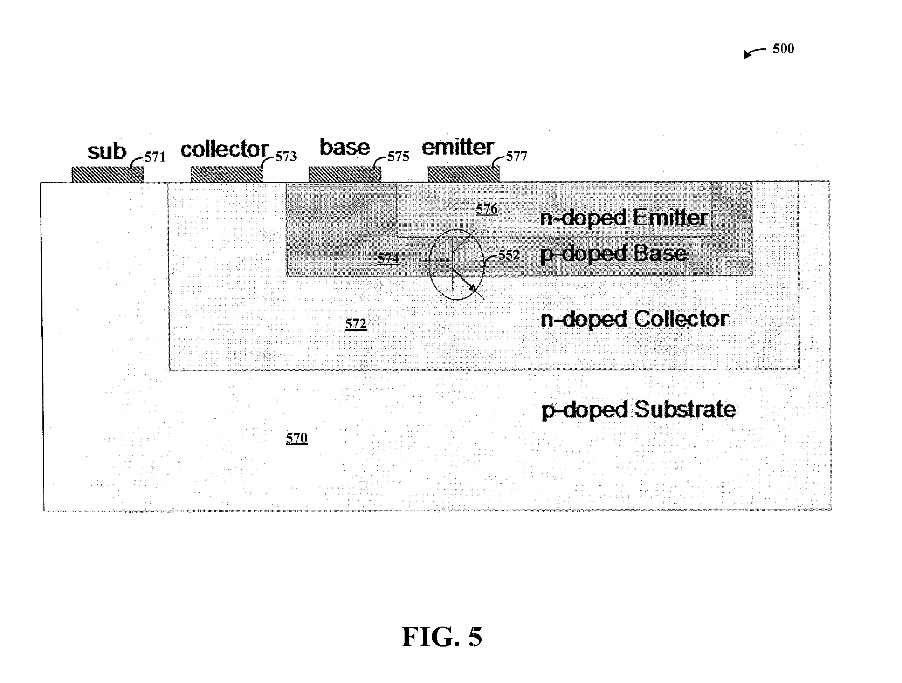

Figures 5-9 show cross-sectional views of ESD protection circuit components, which may be implemented in connection with one or more example embodiments as discussed herein. Beginning with FIG. 5, a cross section is shown of a bipolar circuit 500 used in an on-board ESD protection circuit, according to another example embodiment of the present invention. The diodes and transistors as shown can be manufactured with high gain. In some implementations, the circuit 500 is formed using three diffusion steps and integration of all structures as shown (*e.g.*, and as consistent with one or more of Figures 1-4), for protecting several data lines in one semiconductor device.

The circuit 500 includes a p-doped substrate 570, an n-doped collector 572, a p-doped base 574 and an n-doped emitter 576. These circuit regions 570-576 may, for example, correspond to circuit regions as may be used to form one or more circuits as shown in Figures 1-4 (*e.g.*, with representative npn transistor 552 corresponding to transistor 352 in FIG. 3). Each of the regions 570-576 has a corresponding contact, respectively including a substrate contact 571, collector contact 572, base contact 575 and emitter contact 577. These contacts can be used, for example, to effect connectivity as shown in Figures 1-4 as appropriate.

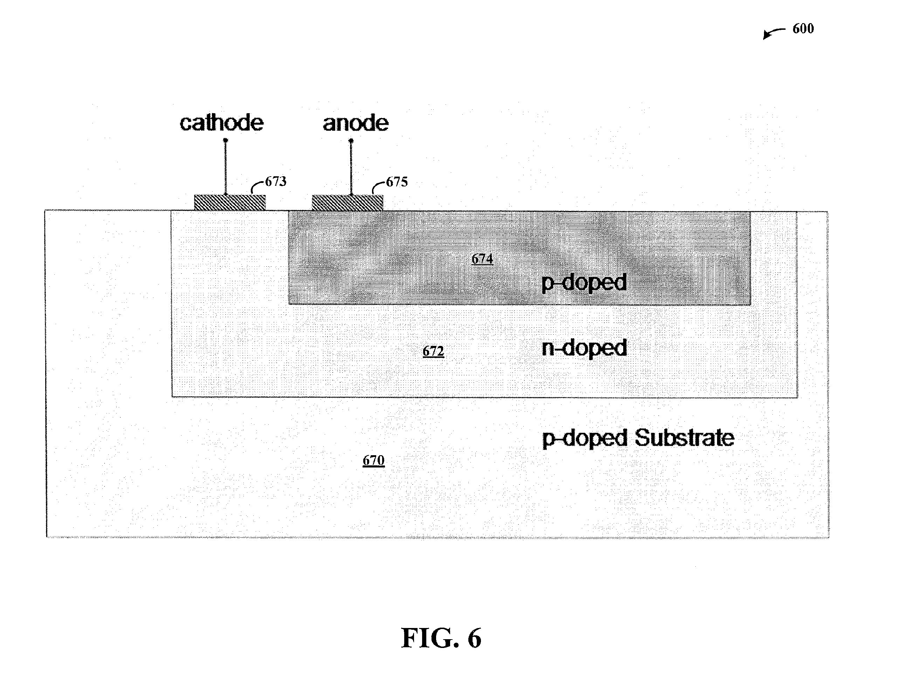

FIG. 6 shows a cross section of a diode circuit 600 used in an on-board ESD protection circuit, according to another example embodiment of the present invention. The diode circuit 600 may, for example, be implemented in connection with one of more of the diodes connected to inputs as shown in Figures 1-4, such as diodes 120, 122, 124 and 126 shown in FIG. 1.

The diode circuit 600 includes a p-doped substrate 670, an n-doped region 672 and a p-doped region 674. The respective n-doped region 672 and p-doped region 674 are connected to cathode and anode contacts 673 and 675. Each of the diodes connected to input pins, such as 120 of FIG. 1, use the base-collector junction formed by regions 672 and 674. These regions may, for example, be formed in connection with correspondingly-doped regions as shown in FIG. 5, as part of an integrated process. This combined approach follows through to the other components in the ESD protection circuits as shown in connection with Figures 1-4 and further as discussed below.

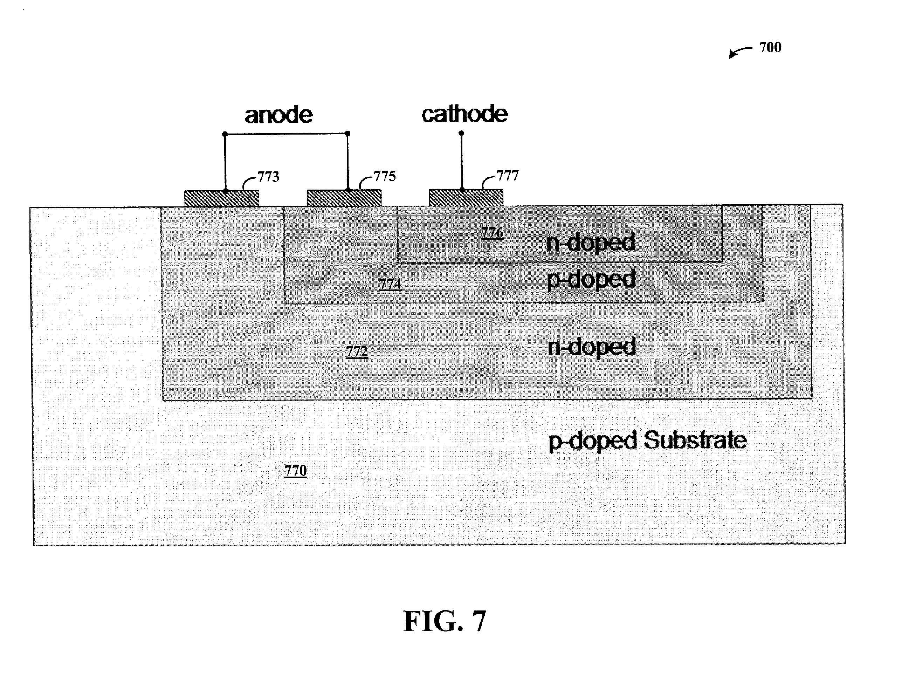

FIG. 7 shows a cross section of a diode circuit 700 used to form a diode string for on-board ESD protection, according to another example embodiment of the present invention. The circuit 700 may, for example, be implemented with the formation of diodes (D1 to Dn) in diode strings as discussed above (*e.g.*, diodes 130, 132 and 134 of FIG. 1). The circuit 700 includes p-doped substrate region 770, n-doped region 772, p-doped region 774 and n-doped region 776, with the latter three regions connected to anode contact 773, anode contact 775 and cathode contact 777, respectively. Effectively, the emitter diffusion (corresponding to 576 in FIG. 5) is used as the cathode, the base diffusion (corresponding to 574 in FIG. 5) is used as the anode of the diode, and with the collector diffusion (corresponding to 572 in FIG. 5) also connected to the anode. Using this arrangement, there is no effective parasitic transistor to substrate, mitigating leakage of diode strings that can occur in other structures, and further insulating the diode from the substrate.

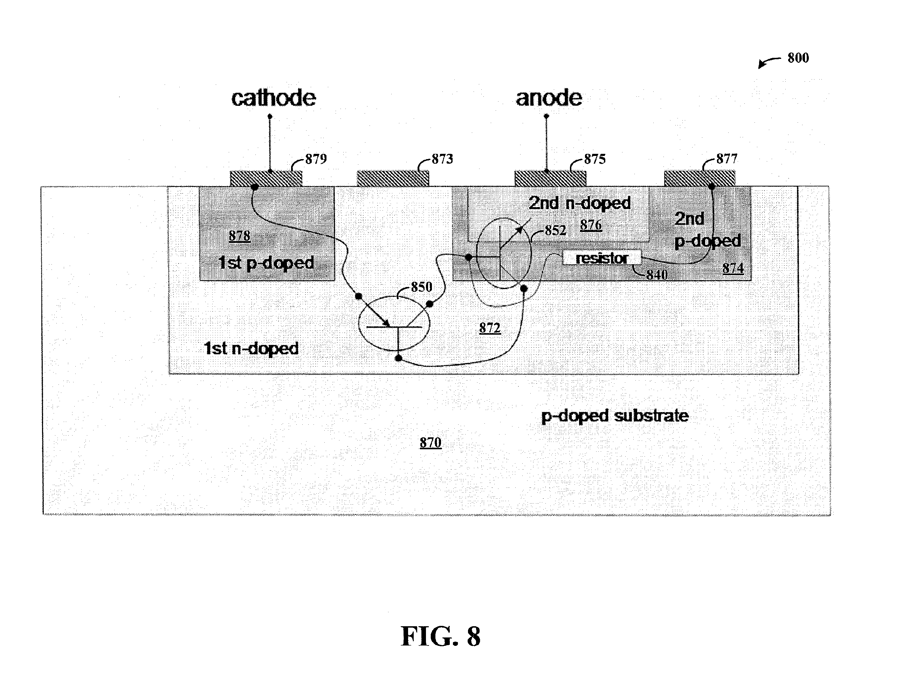

FIG. 8 shows a cross section of an SCR circuit 800 used in an on-board ESD protection circuit, according to another example embodiment of the present invention. The circuit 800 may, for example, be used as one of the SCR circuits shown in Figures 1-4. The circuit 800 includes a p-doped substrate 870, in which the SCR is formed. The SCR includes a first p-doped region 878, a first n-doped region 872, a second p-doped region 874 and a second n-doped region 876. These SCR regions may, for example, respectively correspond to regions 210, 212, 214 and 216 as shown in FIG. 2. The npn-transistor 852 formed by the emitter-base-collector- (876-874-872) may, for example correspond to npn-transistor 352 shown in FIG. 3. Similarly the pnp transistor 850 formed by the base-collector-base (874-872-878) may, for example, correspond to pnp transistor 350 shown in FIG. 3. A resistor 840 (*e.g.*, corresponding to resistor 240 in FIG. 2) is formed by the 2^{nd} p-doped (base diffusion) region 874 below the 2^{nd} n-doped (emitter diffusion) region 876.

Referring back to FIG. 2, the circuit 800 can be implemented as the SCR therein as follows. Cathode contact 879 for the first p-doped region 878, corresponding to p-doped region 210, is connected to VDD. Anode contact 875 to the second n-doped region 876, corresponding to n-doped region 216, is connected to ground. Contact 877 to p-doped region 874 is made to ground as well, as is the resistor 240. Contact 873 to the first n-doped region 872 can be made to the anode of a diode for the diode string (e.g., as shown in FIG. 7 as well).

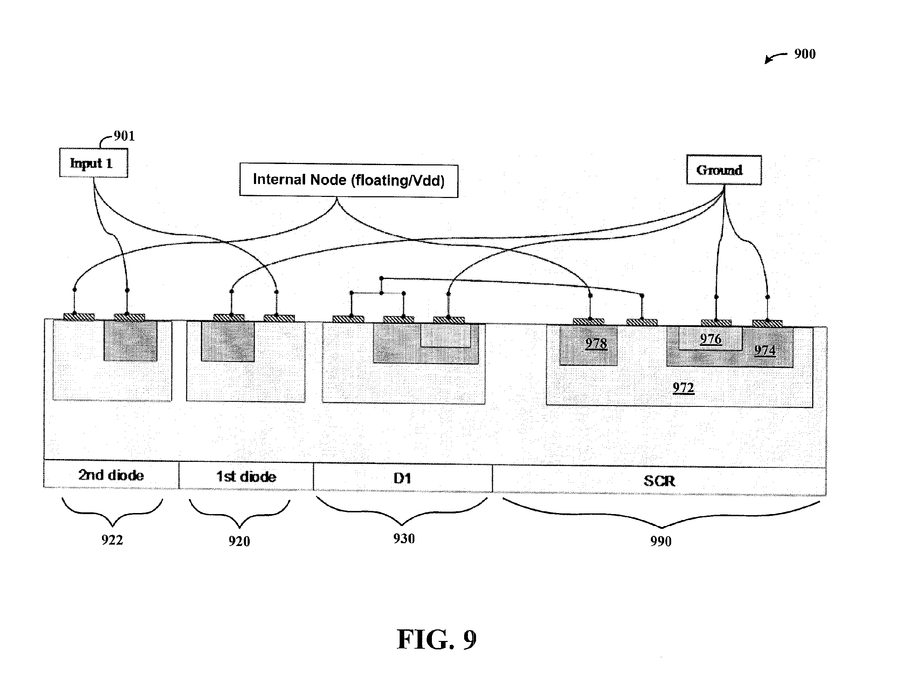

FIG. 9 shows a cross section of a clamp circuit 900 used in an on-board ESD protection circuit, according to another example embodiment of the present invention. The circuit 900 may, for example, be implemented as clamp circuit 460 shown in FIG. 4, with a single diode 930 corresponding to diode 430 in the diode string represented by diodes 430, 432 and 434. A first diode 920 and second diode 922 are connected to a first input 901, in a manner similar to that with the diodes 420/422 and input 401. An SCR circuit 990, similar to the circuit 800 shown in FIG. 8, includes regions 978, 972, 974 and 976 as corresponding to similarly-referenced regions in FIG. 8 and also respectively to regions 410, 412, 414 and 416 in FIG. 4.

Based upon the above discussion and illustrations, those skilled in the art will readily recognize that various modifications and changes may be made to the present invention without strictly following the exemplary embodiments and applications illustrated and described herein. For example, different numbers of diodes in a diode string, different (or additional) resistors, and other related circuits may be implemented. Many applications are implemented with input pins corresponding to devices connected via data exchange ports such as those employed with universal serial bus (USB) or high-definition multimedia interface (HDMI) receiver/transceiver circuits. Such modifications do not depart from the true spirit and scope of the present invention, including that set forth in the following claims.

Further aspects of the present disclosure are according to the following series of numbered clauses:
1. A discharge circuit configured to discharge electrostatic charge in a circuit including an input node respectively connected to an internal node and to ground via intervening diodes, the discharge circuit comprising:
   a thyristor having anode and cathode end regions separated by two base regions, the cathode end region being connected to an internal node, and the anode end region being connected to ground;
   at least one diode connected between one of the base regions of the thyristor and one of either the internal node or ground; and
   a resistor connected between the other one of the base regions that the at least one diode string is not connected to, and the one of either the internal node or ground that the at least one diode is connected to.
2. The circuit of clause 1, wherein
   the at least one diode is connected between the internal node and to the thyristor base region immediately adjacent the thyristor anode, and
   the resistor is connected to the internal node and to the thyristor base region immediately adjacent the thyristor cathode.
3. The circuit of clause 1 12, wherein
   the at least one diode includes a first diode having its anode connected to the internal node and another diode between the first diode and the thyristor with its cathode connected to the thyristor base region immediately adjacent the thyristor anode, and
   the resistor is connected to the internal node and to the thyristor base region immediately adjacent the thyristor cathode.
4. The circuit of clause 1, wherein
   the at least one diode is connected between ground and to the thyristor base region immediately adjacent the thyristor cathode, and
   the resistor is connected to ground and to the thyristor base region immediately adjacent the thyristor anode.
5. The circuit of clause 1, wherein
   the at least one diode includes a first diode having its anode connected to the thyristor base region immediately adjacent the thyristor cathode, and another diode connected between the first diode and ground with its cathode connected to ground, and
   the resistor is connected to ground and to the thyristor base region immediately adjacent the thyristor anode.
6. The circuit of clause 1, wherein
   the diode connected between the input node and the internal node has its anode connected to the input node and its cathode connected to ground,
   the diode connected between the input node and ground has its cathode connected to the input node and its anode connected to ground,
   the thyristor is configured to pass current from the input node to ground in response to a voltage applied to the input node being higher than the sum of the forward voltages of the diode having its anode connected to the input node, the at least one diode connected between one of the base regions of the thyristor and one of either the internal node or ground, and the base-emitter region of the thyristor including the base region to which the at least one diode is coupled and the thyristor cathode.
7. For use in a circuit including an input node respectively connected to an internal node and to ground via intervening diodes, an electrostatic discharge circuit comprising:
   a plurality of diode-based doped regions of opposite polarity forming p-n junctions therebetween, the plurality of doped regions being connected between the internal node and ground and configured to pass current from the input node to ground in response to a voltage applied to the input node being higher than the sum of the forward voltages of one of the intervening diodes having its anode connected to the input node and the plurality of diode-based doped regions;
   a plurality of contiguous thyristor-based doped regions of opposite polarity connected between the internal node and ground, the thyristor-based doped regions including two of said plurality of diode-based doped regions of opposite polarity and at least two other contiguous doped regions;
   a resistor connected to one of the at least two other contiguous doped regions contacting one of the two of said plurality of diode-based doped regions and configured, with the one of the at least two other contiguous doped regions, to flow collector current between the internal node and ground via emitter-base junction effects, in response to the current passing from the input node to ground via the diode-based doped regions;
   the contiguous thyristor-based doped regions being further configured to, in response to the collector current through the resistor causing the voltage drop across the resistor to be higher than the forward voltage of a p-n junction of the at least two other contiguous doped regions, turn on and switch to a low resistive state to flow current between the internal node and ground.
8. The circuit of clause 7, wherein
   the plurality of contiguous thyristor-based doped regions of opposite polarity connected between the internal node and ground consist of four contiguous regions of opposite polarity that form a thyristor, the four contiguous regions including two end regions separated by two base regions,
   the a plurality of diode-based doped regions of opposite polarity forming p-n junctions therebetween consist of a diode string including at least one diode connected between one of the base regions and one of the internal node and ground,
   the resistor is connected to the other one of the base regions that the diode string is not connected to, and the one of the internal node and ground that the diode string is connected to, and
   the intervening diodes include
   a first input diode having its anode connected to the input node and its cathode connected to the internal node, and
   a second input diode having its cathode connected to the input node and its anode connected to ground.
9. The circuit of clause 8, further including
   a second input node connected between the internal node and ground in parallel with the thyristor,
   a third input diode having its anode connected to the input node and its cathode connected to the internal node, and
   a fourth input diode having its cathode connected to the input node and its anode connected to ground, the thyristor, resistor and diode string being configured to conduct current to discharge ESD on the first and second input nodes.

In summary, hereinafter is disclosed an integrated circuit device provides electrostatic discharge (ESD) protection. In connection with various example embodiments, an ESD circuit includes a low voltage clamp circuit configured to discharge current during an ESD event in response to a voltage level presented thereto, and is coupled across an internal node (*e.g.*, a floating circuit node or a voltage supply (VDD)) and ground, in parallel with an input node having a diode between the input node and each of the internal node and ground. The clamp circuit includes a silicon-controlled rectifier (SCR) including a thyristor having anode and cathode end regions separated by two base regions, the cathode being connected to the internal node and the anode being connected to ground. A diode string circuit is connected to one of the internal node and ground, and to one of the base regions, and a resistor is connected to the one of the internal node and ground that the diode string circuit is connected to, and to the one of the base regions that the diode string circuit is not connected to.

## Claims

1. An electrostatic discharge (ESD) circuit comprising:
an input node connected between an internal node and ground;
a diode having its anode connected to the input node and its cathode connected to an internal node;
another diode having its cathode connected to the input node and its anode connected to ground; and
a low voltage clamp circuit configured to discharge current during an ESD event in response to a voltage level presented thereto, the circuit including
a silicon-controlled rectifier (SCR) including a thyristor having anode and cathode end regions separated by two base regions, the cathode being connected to the internal node and the anode being connected to ground,
a diode string circuit connected to one of the internal node and ground, and to one of the base regions, and
a resistor circuit connected to the one of the internal node and ground that the diode string circuit is connected to, and to the one of the base regions that the diode string circuit is not connected to.

2. The circuit of claim 1, wherein
the diode string circuit is connected to thyristor base region immediately adjacent the thyristor anode, and
the resistor circuit is connected to the internal node and to the thyristor base region immediately adjacent the thyristor cathode.

3. The circuit of claim 1, wherein
the diode string circuit includes a diode having its anode connected to the internal node, and a diode having its cathode connected to the thyristor base region immediately adjacent the thyristor anode, and
the resistor circuit is connected to the internal node and to the thyristor base region immediately adjacent the thyristor cathode.

4. The circuit of claim 1, wherein
the diode string circuit is connected to ground and to the thyristor base region immediately adjacent the thyristor cathode, and
the resistor circuit is connected to ground and to the thyristor base region immediately adjacent the thyristor anode.

5. The circuit of claim 1, wherein
the diode string circuit includes a diode having its anode connected to the thyristor base region immediately adjacent the thyristor cathode, and a diode having its cathode connected to ground, and
the resistor circuit is connected to ground and to the thyristor base region immediately adjacent the thyristor anode.

6. The circuit of claim 1, wherein the diode string circuit is configured to set a breakdown voltage of the thyristor to a voltage corresponding to a VDD voltage at the internal node.

7. The circuit of claim 1, wherein the resistor circuit is integrated in the SCR.

8. The circuit of claim 1, wherein the low voltage clamp circuit is configured to pass current from the input node to ground in response to a voltage applied to the input node being higher than the sum of the forward voltages of the diode having its anode connected to the input node, the diodes in the diode string circuit, and the base-emitter region of the thyristor including the base region to which the diode string circuit is coupled and the thyristor cathode.

9. The circuit of claim 1, wherein the low voltage clamp circuit is configured to
pass current from the input node to ground in response to a voltage applied to the input node being higher than the sum of the forward voltages of the diode having its anode connected to the input node, the diodes in the diode string circuit, and the base-emitter junction of the thyristor including the base region to which the diode string circuit is coupled and the thyristor cathode, and
in response to the current passing from the input node to ground in response to said applied voltage, the current flowing through the emitter-base junction effects current flow from through the resistor circuit and the base-emitter junction.

10. The circuit of claim 1, wherein the low voltage clamp circuit is configured to
pass current from the input node to ground in response to a voltage applied to the input node being higher than the sum of the forward voltages of the diode having its anode connected to the input node, the diodes in the diode string circuit, and the base-emitter junction of the thyristor including the base region to which the diode string circuit is coupled and the thyristor cathode,
in response to the current passing from the input node to ground in response to said applied voltage, the current flowing through the emitter-base junction effects current flow from through the resistor circuit and the base-emitter junction, and
in response to the collector current through the resistor causing the voltage drop across the resistor to be higher than the forward voltage of the p-n junction of the anode and the base region immediately adjacent the anode, the SCR turns on and switches to a low resistive state to flow current.

11. The circuit of claim 1, further including
another input node connected between the internal node and ground and, for the other input node,
a diode having its anode connected to the other input node and its cathode connected to the internal node,
another diode having its cathode connected to the other input node and its anode connected to ground, and
the low voltage clamp circuit being configured to pass current to mitigate electrostatic discharge for both of the input nodes.
